(19) Europäisches Patentamt
European Patent Office
Office européen des brevets

(11) **EP 4 450 928 B1**

(12) **FASCICULE DE BREVET EUROPEEN**

(45) Date de publication et mention
de la délivrance du brevet:
**25.06.2025 Bulletin 2025/26**

(21) Numéro de dépôt: **24170876.7**

(22) Date de dépôt: **17.04.2024**

(51) Classification Internationale des Brevets (IPC):
*H01M 10/44* (2006.01)  *G01F 15/00* (2006.01)
*H10N 10/00* (2023.01)  *G01F 1/00* (2022.01)
*G01F 1/66* (2022.01)  *H01M 8/04298* (2016.01)
*H01M 16/00* (2006.01)  *H10N 10/13* (2023.01)
*H10N 10/17* (2023.01)

(52) Classification Coopérative des Brevets (CPC):
**G01F 15/00; G01F 1/00; G01F 1/66; H01M 10/44;
H10N 10/00; H10N 10/13; H10N 10/17**

(54) **COMPTEUR DE FLUIDE AVEC SOURCE ALTERNATIVE D'ALIMENTATION ÉLECTRIQUE**

FLÜSSIGKEITSZÄHLER MIT ALTERNATIVER STROMVERSORGUNG

FLUID METER WITH ALTERNATIVE POWER SUPPLY

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **21.04.2023 FR 2304059**

(43) Date de publication de la demande:
**23.10.2024 Bulletin 2024/43**

(73) Titulaire: **SAGEMCOM ENERGY & TELECOM SAS
92270 Bois-Colombes (FR)**

(72) Inventeur: **TEBOULLE, Henri
92270 Bois-Colombes (FR)**

(74) Mandataire: **Regimbeau
20, rue de Chazelles
75847 Paris Cedex 17 (FR)**

(56) Documents cités:
**WO-A1-2016/140035    JP-A- 2002 270 908
US-A1- 2006 063 044    US-A1- 2010 104 896**

## Description

**DOMAINE TECHNIQUE**

L'invention appartient au domaine technique des compteurs de fluide. Un compteur de fluide est un appareil de métrologie configuré pour effectuer des mesures métrologiques dans une canalisation de circulation de fluide. Le fluide peut être liquide, comme par exemple de l'eau ou du pétrole, ou gazeux, comme par exemple un mélange gazeux d'hydrocarbures constitué principalement de méthane tel que le gaz naturel. Les mesures métrologiques sont généralement un volume ou un débit relatif au fluide circulant dans la canalisation.

**ETAT DE LA TECHNIQUE**

Afin de connaître certaines données métrologiques concernant la circulation d'un fluide dans une canalisation, un compteur de fluide est habituellement utilisé pour générer et rendre disponibles des mesures métrologiques. Afin de relever ces mesures métrologiques, des compteurs de fluide munis de moyens de communication d'informations relatives auxdites données métrologiques ont été développés. Ces moyens de communication peuvent être adaptés pour une communication à distance, et par exemple permettent une transmission filaire ou non de ces informations. Les moyens de communication peuvent également présenter plusieurs informations dans un affichage, organisées selon des menus. Dans tous les cas, ces compteurs métrologiques nécessitent une alimentation électrique. Or, les compteurs peuvent être disposés dans des emplacements ne permettant pas un raccordement aisé au réseau électrique, de sorte qu'ils doivent disposer d'une alimentation électrique autonome, non raccordée au réseau électrique.

La façon la plus simple d'alimenter en électricité de façon autonome un compteur de fluide est de munir celui-ci d'une pile électrique, c'est-à-dire d'un élément de stockage d'énergie non rechargeable in-situ. La capacité de stockage d'énergie doit cependant être suffisante pour permettre une alimentation électrique pendant une longue durée (typiquement 20 ans), ce qui se traduit par l'emploi de piles très volumineuses. En outre, la durée de vie de la pile dépend de la consommation électrique du compteur, qui peut singulièrement réduire la durée de vie de la pile, laquelle de toute façon finit par s'épuiser et doit être changée, opération fastidieuse nécessitant une surveillance de l'état de la pile.

Le document de l'état de l'art JP 2002 270908 A montre un compteur de fluide pour effectuer des mesures métrologiques avec un bloc de commande pour recevoir les mesures et communiquer les informations correspondantes et le compteur comprend un générateur thermoélectrique et une unité de stockage d'énergie.

Afin de pallier ces inconvénients, il a été proposé de remplacer la pile électrique par une batterie rechargeable, par exemple alimentée par un générateur électrique configuré pour être entraîné par la circulation du fluide dans la canalisation et générer de l'électricité rechargeant la batterie.

Toutefois, l'aspect potentiellement intermittent de la circulation du fluide nécessite de disposer d'une batterie avec une capacité de stockage électrique importante, ce qui se traduit par un encombrement et des coûts élevés. En outre, la non régularité des épisodes de circulation de fluide peut multiplier les cycles de charge-décharge incomplet de la batterie, réduisant au cours du temps les performances de celle-ci.

**EXPOSE DE L'INVENTION**

L'invention vise donc à proposer un compteur de fluide muni d'une alimentation électrique avec une longue durée de vie, moins encombrante et plus fiable.

L'invention a pour objet un compteur de fluide configuré pour effectuer des mesures métrologiques dans une canalisation de circulation de fluide et pour communiquer des informations relatives auxdites données métrologiques, comprenant :

- une canalisation de fluide,
- au moins un capteur métrologique configuré pour effectuer des mesures métrologiques dans la canalisation de fluide,
- un bloc de commande configuré pour recevoir les mesures métrologiques et pour communiquer des informations relatives auxdites données métrologiques,
- un bloc d'alimentation configuré pour alimenter en énergie le bloc de commande, le bloc d'alimentation comprenant une première voie d'alimentation comprenant au moins une pile, et une seconde voie d'alimentation, le bloc d'alimentation comprenant en outre un premier commutateur configuré pour coupler sélectivement la première voie d'alimentation ou la seconde voie d'alimentation au bloc de commande.

Le compteur de fluide comprend un générateur thermoélectrique configuré pour produire de l'électricité à partir d'une différence de température entre un extérieur de la canalisation et le fluide dans la canalisation, la seconde voie d'alimentation étant reliée au générateur thermoélectrique.

Ce dispositif est avantageusement complété par les caractéristiques suivantes prises seules ou selon toutes leurs combinaisons techniquement possibles :

- le générateur thermoélectrique comporte un ou plusieurs modules thermoélectriques insérés partiellement dans une paroi de la canalisation ;
- une excroissance est formée sur la canalisation de circulation du fluide, l'excroissance comprenant au moins une cavité , chaque cavité étant configurée pour recevoir un module thermoélectrique ;

- la paroi de la canalisation a une première épaisseur en dehors de l'excroissance , chaque cavité comprenant une partie de protection et une partie de réception , la partie de réception étant d'un diamètre inférieur à la partie de protection et étant ménagée dans la paroi de la canalisation à une distance de l'intérieur de la canalisation inférieure à la première épaisseur , chaque module thermoélectrique comprenant une première portion configurée pour être à la température de l'extérieur de la canalisation et une deuxième portion configurée pour être à la température du fluide , la deuxième portion étant insérée dans la partie de réception ;
- le générateur thermoélectrique comporte un premier connecteur externe en contact avec la première portion d'un premier module thermoélectrique disposé en entrée du générateur thermoélectrique et reliant ladite première portion au bloc d'alimentation , le générateur thermoélectrique comprenant en outre un deuxième connecteur externe en contact avec la deuxième portion d'un dernier module thermoélectrique disposé en sortie du générateur thermoélectrique et reliant ladite deuxième portion au bloc d'alimentation ;
- une deuxième portion d'un module thermoélectrique est reliée par un connecteur interne à la première portion d'un autre module thermoélectrique ;
- chaque module thermoélectrique est composé d'un premier matériau thermoélectrique ayant un premier coefficient de Seebeck , et un connecteur en contact avec la première portion ou la deuxième portion du module thermoélectrique est composé d'un deuxième matériau thermoélectrique ayant un deuxième coefficient de Seebeck différent du premier coefficient de Seebeck ;
- la seconde voie d'alimentation comprend un condensateur et un second commutateur configuré pour sélectivement coupler le condensateur et le générateur thermoélectrique en fonction d'un niveau de charge du condensateur ;
- le niveau de charge est déterminé par le bloc de commande en fonction d'une première table de correspondance et de la différence de température lorsque le condensateur se charge, et en fonction d'une deuxième table de correspondance et de fonctions mises-en-œuvre par le bloc de commande lorsque le condensateur se décharge ;
- le bloc de commande est configuré pour, au moins lorsque le générateur thermoélectrique génère de l'électricité :

  • positionner le premier commutateur sur la seconde voie d'alimentation lorsque le niveau de charge devient supérieur à un seuil haut ;
  • positionner le premier commutateur sur la première voie d'alimentation lorsque le niveau de charge du condensateur devient inférieur à un seuil bas ;

- le seuil haut est supérieur ou égal à 80% d'un niveau de charge maximal , et le seuil bas est inférieur ou égal à 10% du niveau de charge maximal ;
- le bloc de commande est configuré pour déterminer une différence de température entre l'extérieur de la canalisation et le fluide et pour :

  • ouvrir le second commutateur lorsque la différence de température est inférieure à un seuil minimal de différence de température ;
  • fermer le second commutateur lorsque la différence de température est supérieure ou égale à un seuil minimal de différence de température ;

- le seuil minimal de différence de température est compris entre 2°C et 5°C.

L'invention a également pour objet un procédé de gestion de l'alimentation d'un compteur de fluide tel que défini précédemment, le compteur de fluide comprenant un bloc de commande et un bloc d'alimentation configuré pour alimenter en énergie le bloc de commande , le bloc d'alimentation comprenant une première voie d'alimentation comprenant au moins une pile, et une seconde voie d'alimentation , le bloc d'alimentation comprenant en outre un premier commutateur configuré pour coupler sélectivement la première voie d'alimentation ou la seconde voie d'alimentation au bloc de commande , la seconde voie d'alimentation étant reliée à un générateur thermoélectrique configuré pour produire de l'électricité à partir d'une différence de température entre un extérieur de la canalisation et le fluide dans la canalisation , la seconde voie d'alimentation comprenant en outre un condensateur et un second commutateur configuré pour sélectivement coupler le condensateur et le générateur thermoélectrique en fonction d'un niveau de charge du condensateur , le procédé étant apte à être mis-en-œuvre par le bloc de commande et comportant les étapes suivantes :

- Commutation du premier commutateur sur la première voie d'alimentation,
- Détermination d'une différence de température entre un extérieur de la canalisation et le fluide et, lorsque la différence de température déterminée devient supérieure ou égale à un seuil minimal, fermeture du deuxième commutateur,
- Estimation d'un courant de charge à partir de la différence de température et d'une première table de correspondance fournissant une estimation du courant de charge associé pour chaque valeur de la différence de température,
- Détermination d'un niveau de charge du condensateur en charge à partir du courant de charge estimé et, lorsque le niveau de charge estimé devient supérieur ou égal à un seuil haut prédéterminé, commutation du premier commutateur sur la deuxième voie d'alimentation,

- Estimation d'un courant de décharge réalisée à partir de fonctions mises-en-œuvre par le bloc de commande et d'une deuxième table de correspondance fournissant pour chaque fonction mise-en-œuvre par le bloc de commande une estimation du courant de décharge associé,
- Détermination d'un niveau de charge du condensateur en décharge en fonction de l'estimation du courant de décharge et, lorsque le niveau de charge estimé devient inférieur ou égal à un seuil bas de charge prédéterminé, répétition des étapes précédentes.

L'invention a également pour objet un produit programme d'ordinateur apte à être mis-en-œuvre par un bloc de commande d'un compteur de fluide tel que défini précédemment, comprenant des instructions qui, lorsque le programme est exécuté par le bloc de commande, conduisent le bloc de commande à mettre en œuvre le procédé tel que défini ci-dessus.

Enfin, l'invention a également pour objet une mémoire lisible par ordinateur stockant des instructions exécutables par l'ordinateur pour l'exécution des étapes du procédé tel que défini précédemment.

## DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :

- la figure 1 est une vue d'ensemble schématique d'un compteur de fluide selon un mode de réalisation possible de l'invention ;
- la figure 2 est une vue du dessus d'un premier mode de réalisation de l'excroissance et des cavités de la canalisation du compteur de fluide ;
- la figure 3 est une vue du dessus d'un deuxième mode de réalisation de l'excroissance et des cavités de la canalisation du compteur de fluide ; et
- la figure 4 est un diagramme de mise en œuvre d'un compteur de fluide selon un mode de réalisation possible de l'invention.

Sur l'ensemble des figures, les éléments similaires portent des références identiques

## DESCRIPTION DETAILLEE DE L'INVENTION

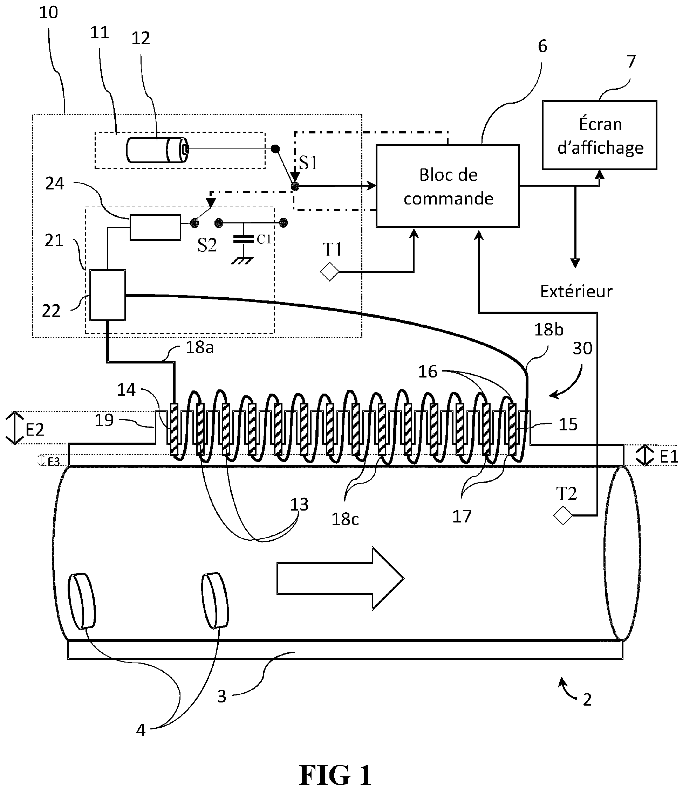

La figure 1 montre un compteur de fluide configuré pour effectuer des mesures métrologiques concernant un fluide circulant dans une canalisation 2 de circulation de fluide définie par une paroi 3 séparant un intérieur de la canalisation 2 dans lequel le fluide circule, et un extérieur à la canalisation 2. Le compteur de fluide est également configuré pour communiquer des informations relatives auxdites données métrologiques. Typiquement, la canalisation 2 de circulation de fluide fait partie du compteur de fluide au sens où le compteur de fluide comprend une portion de conduite dans laquelle circule le fluide, qui est intégrée au réseau de circulation du fluide. Pour effectuer des mesures métrologiques, le compteur de fluide comprend au moins un capteur métrologique 4 configuré pour effectuer des mesures métrologiques dans la canalisation de fluide 2. Le capteur métrologique 4 est de préférence disposé dans la canalisation de fluide 2. Le type de capteur métrologique 4 dépend de la technologie utilisée pour effectuer les mesures, qui peut être une technologie ultrasonore, électromagnétique, thermique ou à effet Coriolis. Dans l'exemple illustré, deux transducteurs ultrasonores sont disposés l'un en face de l'autre dans la canalisation afin de procéder à des mesures métrologiques par ultrasons, de façon connue. Les mesures métrologiques sont généralement un volume ou un débit relatifs au fluide circulant dans la canalisation 2, dérivées des données récoltées par le ou les capteurs métrologiques 4.

Le compteur de fluide comprend un bloc de commande 6 comprenant au moins un processeur et une mémoire, et qui est configuré pour recevoir les mesures métrologiques en provenance du capteur métrologique 4, et pour communiquer les informations relatives auxdites données métrologiques. Typiquement, le capteur métrologique 4 peut être relié au bloc de commande 6, par exemple par une liaison filaire, et transmet les mesures métrologiques au bloc de commande 6.

La communication des informations relatives aux données métrologiques est effectuée par affichage sur un écran et/ou par transmission. Le compteur de fluide peut ainsi disposer d'un écran d'affichage 7 où peuvent être affichées les informations relatives aux données métrologiques. Le compteur de fluide peut être muni d'une interface homme-machine tel qu'un bouton permettant de causer l'affichage de ces informations relatives aux données métrologiques, et éventuellement de faire varier cet affichage, par exemple en permettant d'en faire défiler différents types sur l'écran d'affichage 7. Les informations relatives aux données métrologiques peuvent être transmises à l'extérieur du compteur de fluide, de préférence par une liaison non filaire, auquel cas le compteur de fluide peut comprendre une antenne et tout autre élément connu permettant d'établir une communication à distance avec le compteur de fluide.

De préférence, le compteur de fluide est conforme à la directive de l'Union Européenne 2014/32/EU concernant les instruments de mesure, plus connu sous l'acronyme anglais de MID pour « Measuring Instruments Directive ». En particulier, le compteur de fluide doit pouvoir en permanence être capable de communiquer des informations relatives aux données métrologiques. De même, le compteur de fluide doit pouvoir à tout moment permettre de procéder aux mesures métrologiques. Par conséquent, le compteur de fluide doit disposer en permanence d'une alimentation électrique.

A cet effet, le compteur de fluide comprend un bloc d'alimentation 10 configuré pour alimenter en permanence en électricité le bloc de commande 6, et un générateur thermoélectrique 30 configuré pour produire de l'électricité à partir des températures du fluide et de l'extérieur de la canalisation 2, le bloc d'alimentation 10 étant couplé au générateur thermoélectrique 30. Le générateur thermoélectrique 30 est configuré pour produire de l'électricité grâce à l'effet Seebeck, qui est un effet thermoélectrique, par lequel une différence de potentiel apparaît à la jonction de deux matériaux soumis à une différence de température.

Le bloc d'alimentation 10 comprend deux voies distinctes et indépendantes : une première voie d'alimentation 11 comprenant au moins une pile 12 et une seconde voie d'alimentation 21 reliée au générateur thermoélectrique 30. On entend par pile (ou « primary cell » en anglais) un élément de stockage d'énergie électrique qui ne peut pas être rechargée, ou dont la configuration dans le bloc d'alimentation 10 rend impossible la charge au sein de ce bloc d'alimentation 10. Typiquement, la première voie d'alimentation 11 comprend uniquement la pile 12. La pile 12 présente de préférence une réserve d'énergie maximale inférieure à 100 Wh, comme par exemple 30,6 Wh (8,5 Ah sur 3,6 V) ou 68,4 Wh (19 Ah sur 3,6 V).

Le bloc d'alimentation 10 comprend un premier commutateur S1 configuré pour coupler sélectivement la première voie d'alimentation 11 ou la seconde voie d'alimentation 21 au bloc de commande 6, sélectionnant ainsi si le bloc de commande 6 est alimenté électriquement par la première voie d'alimentation 11 ou la seconde voie d'alimentation 21.

La seconde voie d'alimentation 21 comprend en outre un condensateur C1 et un second commutateur S2 configuré pour sélectivement coupler ou découpler le condensateur C1 et le générateur thermoélectrique 30. Le condensateur C1 présente de préférence une réserve d'énergie maximale Emax supérieure ou égale à 0.5 Wh, et de préférence encore supérieure ou égale à 0.8 Wh. Par exemple, le condensateur C1 peut délivrer une charge électrique de 0.222 Ah sur 3.6 V. Le condensateur C1 est de préférence un supercondensateur. Typiquement, le condensateur C1 peut être un supercondensateur à couche hybride, ou HLC pour l'anglais « Hybrid Layer Capacitor », mais peut également être tout type de supercondensateur permettant d'offrir une réserve d'énergie maximale Emax supérieure ou égale à 0.5 Wh. De préférence, l'énergie maximale Emax du condensateur C1 est inférieure d'au moins 20 fois à l'énergie maximale de la pile 12.

Le second commutateur S2 est disposé entre le condensateur C1 et le générateur thermoélectrique 30. Le second commutateur S2 est commandé par le bloc de commande 6 pour son ouverture et sa fermeture. Le second commutateur S2 est de préférence un relais, par exemple un relais électromécanique.

La seconde voie d'alimentation 21 peut comprendre, en série entre le générateur thermoélectrique 30 et le deuxième commutateur S2, différents éléments de mise en forme du courant, et par exemple un redresseur 22 en série avec un régulateur de tension 24. Dans l'exemple illustré, un premier terminal du condensateur C1 est raccordé entre le premier commutateur S1 et le second commutateur S2, et un second terminal du condensateur C1 est connecté à un potentiel de référence (exemple : la masse).

Le bloc de commande 6 est configurée pour déterminer une différence de températures $\Delta T$ entre l'extérieur de la canalisation 2, dont la température est notée $T_{amb}$ et le fluide, dont la température est notée $T_{fluide}$ ($\Delta T = T_{amb} - T_{fluide}$). Plus précisément, le bloc de commande 6 détermine la différence de température $\Delta T$ à partir de mesures de températures réalisées par un premier capteur de température T1 configuré pour mesurer la température $T_{amb}$ de l'extérieur de la canalisation 2, typiquement l'air ambiant, et par un deuxième capteur de température T2 configuré pour mesurer la température $T_{fluide}$ du fluide, les premier et deuxième capteurs de températures T1 et T2 étant connectés au bloc de commande 6 pour transmettre leurs mesures respectives. Les capteurs de températures T1, T2 sont par exemple des thermocouples. Le deuxième capteur T2 est par exemple noyé dans la paroi de la canalisation 2, et/ou peut être en contact avec le fluide.

Le générateur thermoélectrique 30 comporte un ou plusieurs modules thermoélectriques 13 de préférence identiques et raccordés entre eux en série. En d'autres termes, les modules thermoélectriques 13 forment une chaîne de modules thermoélectriques s'étendant entre un premier module thermoélectrique 14 et un dernier module thermoélectrique 15.

Dans le cas où le générateur thermoélectrique 30 ne comprend qu'un seul module thermoélectrique 13, ce module 13 est à la fois le premier module 14 et le dernier module 15 de la chaine thermoélectrique.

Chaque module thermoélectrique 13, 14, 15 comprend une première portion 16 configurée pour être disposée au niveau de l'extérieur de la canalisation 2 et une deuxième portion 17 configurée pour être disposée au niveau et à proximité du fluide. Plus précisément, la première portion 16, respectivement la deuxième portion 17, est configurée pour être à la température $T_{amb}$ de l'extérieur de la canalisation 2, respectivement à la température $T_{fluide}$ du fluide. Dans un mode de réalisation, la première portion 16 comprend une première extrémité du module 13, 14, 15, et/ou la deuxième portion 17 comprend une deuxième extrémité du module 13, 14, 15. De préférence, les modules thermoélectriques 13, 14, 15 sont cylindriques, et par exemple tubulaire de diamètre constant, de manière à faciliter leur installation.

Le générateur thermoélectrique 30 comporte en outre un premier connecteur externe 18a en contact avec la première portion 16 du premier module thermoélectrique 14 et reliant ladite première portion 16 du premier module thermoélectrique 14 au bloc d'alimentation 10.

Le générateur thermoélectrique 30 comprend également un deuxième connecteur externe 18b en contact avec la deuxième portion 17 du dernier module thermoélectrique 15 et reliant cette deuxième portion 17 du dernier module thermoélectrique 15 au bloc d'alimentation 10. Typiquement, le premier connecteur externe 18a et le deuxième connecteur externe 18b sont des fils fixés, par exemple par soudure, à un module thermoélectrique 14, 15.

Plus précisément, dans un mode de réalisation, les premier et deuxième connecteurs externes 18a, 18b relient respectivement la première portion 16 du premier module 14 et la deuxième portion 17 du dernier module 15 au redresseur 22.

Dans un mode de réalisation, les connecteurs externes 18a, 18b sont reliés au bloc d'alimentation 10 par l'intermédiaire de connexions électriques intermédiaires. Alternativement, les connecteurs externes 18a, 18b s'étendent jusqu'au bloc d'alimentation 10.

En outre, les deuxièmes portions 17 de chaque module thermoélectrique 13, 14 hormis le dernier module 15, sont reliées par un connecteur interne 18c à la première portion 16 d'un autre module thermoélectrique 13, 15. Le connecteur interne 18c est ainsi au contact des première et deuxième portions 16, 17 reliées.

Par exemple, le contact des connecteurs externes 18a, 18b et des connecteurs internes 18c à leurs modules thermoélectriques 13, 14, 15 respectifs se fait par soudure. Les connecteurs internes 18c sont par exemple des fils métalliques.

Dans un mode de réalisation, les connecteurs externes 18a, 18b et internes 18c sont identiques.

Les modules thermoélectriques 13, 14, 15 sont composés d'un premier matériau thermoélectrique conducteur ayant un premier coefficient de Seebeck $S_A$ donné. De plus, les connecteurs externes 18a, 18b et internes 18c sont composés d'un deuxième matériau thermoélectrique conducteur ayant un deuxième coefficient de Seebeck $S_B$ donné différent du premier coefficient de Seebeck $S_A$.

Dans le cas où le compteur de fluide est destiné à être disposé dans un environnement dans lequel la température $T_{amb}$ de l'extérieur de la canalisation est généralement supérieure à la température du fluide $T_{fluid}$, (par généralement, on entend au moins 50% du temps), c'est-à-dire par exemple dans le cas d'un compteur d'eau froide disposé à l'intérieur d'un bâtiment, les premier et deuxième matériaux thermoélectriques sont choisis de sorte que le deuxième coefficient de Seebeck $S_B$ est supérieur au premier coefficient de Seebeck $S_A$, et de préférence supérieur d'au moins 2 ou 4 μV/K. Ainsi dans un tel cas, la premier coefficient de Seebeck $S_A$ est de préférence relativement faible, par exemple négatif, tandis que le deuxième coefficient de Seebeck $S_B$ est de préférence relativement élevé, par exemple positif. Par exemple dans un tel cas, le premier matériau thermoélectrique est de l'aluminium, du fer, ou un oxyde de Molybdène, et le deuxième matériau thermoélectrique est du cuivre, du nickel, du titanate de strontium ou est un polyélectrolyte solide.

Au contraire, dans le cas où le compteur de fluide destiné à être disposé dans un environnement dans lequel la température $T_{amb}$ de l'extérieur de la canalisation est généralement inférieure à la température du fluide $T_{fluide}$ (par généralement, on entend au moins 50% du temps), c'est-à-dire par exemple dans le cas d'un compteur d'eau chaude, les premier et deuxième matériaux thermoélectriques sont choisis de sorte que le deuxième coefficient de Seebeck $S_B$ est inférieur au premier coefficient de Seebeck $S_A$, et de préférence inférieur d'au moins 2 ou 4 μV/K. Ainsi, par exemple dans un tel cas, le premier matériau thermoélectrique formant les modules thermoélectriques 13, 14, 15 est du cuivre, du nickel, du titanate de strontium ou est un polyélectrolyte solide, et par exemple, le deuxième matériau thermoélectrique formant les connecteurs externes 18a, 18b et internes 18c est de l'aluminium, du fer, ou un oxyde de Molybdène.

En tout état de cause, dans tous les cas, le deuxième coefficient de Seebeck $S_B$ est différent du premier coefficient de Seebeck $S_A$, et de préférence différent d'au moins 2 ou 4 μV/K au moins, de sorte qu'une différence de potentiel $\Delta V$ est générée au sein de chaque module 13, 14, 15 entre la première portion 16 et la deuxième portion 17 du fait du contact entre lesdites portions 16, 17 et les connecteurs 18a, 18b, 18c lorsqu'il existe une différence de température $\Delta T$ entre la température $T_{amb}$ de l'extérieur de la canalisation 2 et la température du fluide $T_{fluide}$ ($\Delta T = T_{amb} - T_{fluide}$). La différence de potentiel entre les deux points de contacts entre un module thermoélectrique 13, 14, 15 et des connecteurs 18a, 18b, 18c, c'est-à-dire entre les première et deuxième portions 16 et 17, est définie par la relation suivante :

$$\Delta V = (S_B - S_A) \times \Delta T$$

Ainsi, dans tous les cas décrits précédemment, les matériaux thermodynamiques sont choisis de sorte que la différence de potentiel entre les deux points de contacts entre un module thermoélectrique 13, 14, 15 et des connecteurs 18a, 18b, 18c demeure généralement positive (au moins 50% du temps, tant que la différence de température $\Delta T$ entre la température $T_{amb}$ de l'extérieur de la canalisation 2 et la température du fluide $T_{fluid}$, est de même signe que la différence entre le deuxième coefficient de Seebeck $S_B$ et le premier coefficient de Seebeck $S_A$).

De plus, les modules thermoélectriques 13, 14, 15 étant assemblés en série, les différences de potentiel $\Delta V$ s'ajoutent les unes aux autres, de sorte qu'aux bornes du redresseur 22, les connecteurs externes 18a et 18b produisent une différence de potentiel égale à ΔV multiplié par le nombre de modules thermoélectriques assemblés en série dans le générateur thermoélectrique 30. Ainsi, l'intérêt est d'assembler un grand nombre de modules 13, 14, 15 afin d'augmenter proportionnellement la production d'électricité.

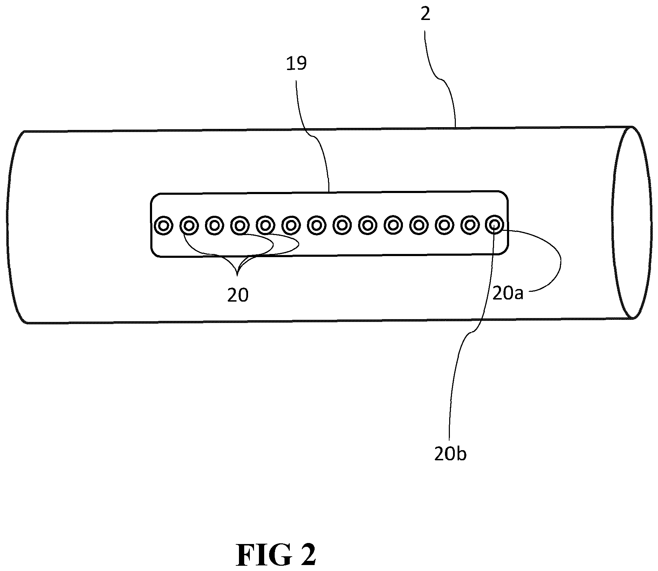

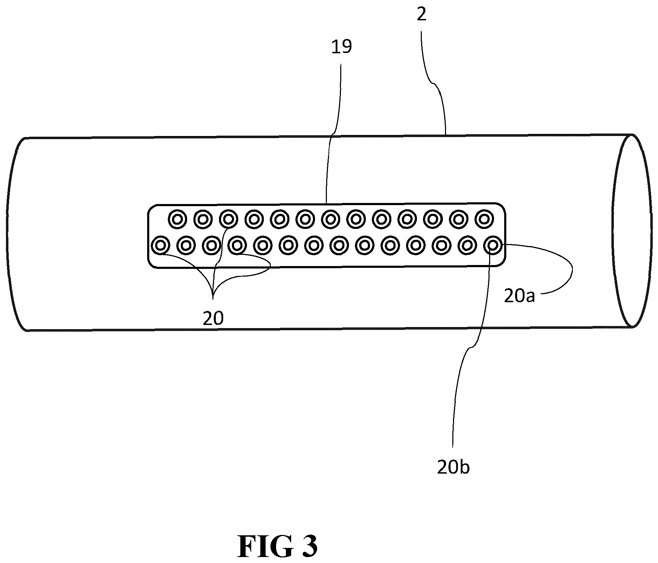

Par exemple, le générateur thermoélectrique 30 comporte un nombre N valant 14 ou 27 de modules thermoélectriques 13, 14, 15, ainsi que représenté dans des exemples illustrés sur les figures 2 et 3. Toutefois, le nombre N peut prendre toute autre valeur suivant les contraintes ou les besoins de l'utilisateur.

Afin de loger les modules thermoélectriques 13, 14, 15 et plus globalement le générateur thermoélectrique 30, la canalisation 2 comprend une excroissance 19 formée sur une surface externe (c'est-à-dire au contact de l'extérieur) de la canalisation 2. Plus précisément, l'excroissance 19 s'étend radialement vers l'extérieur (c'est-à-dire dans une direction opposée à la position du fluide) depuis la canalisation 2 par rapport à un axe d'écoulement du fluide dans la canalisation 2 représenté par une flèche dans le mode de réalisation dont un exemple est illustré sur la figure 1.

L'excroissance 19 comprend une ou plusieurs cavités 20 formant des logements configurés pour recevoir les modules thermoélectriques 13, 14, 15. En particulier, chaque cavité 20 est configurée pour recevoir un module thermoélectrique 13, 14, 15. Dans un mode de réalisation, l'excroissance 19 comprend autant de cavités 20 que le générateur thermoélectrique 30 comporte de modules thermoélectriques 13, 14, 15.

Les cavités 20 peuvent être pratiqués dans l'excroissance 19 de sorte à être alignées, comme dans l'exemple illustré sur la figure 2, ou en quinconce, comme dans l'exemple illustré sur la figure 3, afin de pouvoir loger plus de modules 13, 14, 15 dans un espace réduit. Ces exemples ne sont pas limitatifs.

Chaque cavité 20 est borgne et s'étend dans l'excroissance 19 radialement par rapport à l'axe d'écoulement du fluide. Plus précisément, chaque cavité 20 débouche sur l'extérieur de la canalisation 2, et s'étend dans l'excroissance 19 jusqu'à un point intérieur de la paroi 3 de la canalisation 2 suffisamment proche du fluide pour que le fond de la cavité 20 soit sensiblement à la température du fluide s'écoulant dans la canalisation 2.

Dans une forme de réalisation, chacune des cavités 20 comprend une partie de protection 20a et une partie de réception 20b superposées radialement, la partie de réception 20b constituant la portion de la cavité 20 la plus profonde dans la paroi 3 de la canalisation 2 comportant l'excroissance 19 et donc la plus proche du fluide. En d'autres termes, la partie de protection 20a s'étend entre l'extrémité débouchante de la cavité 20 sur l'extérieur de la canalisation 2 et la partie de réception 20b.

Plus précisément, la paroi 3 de la canalisation 2 a une première épaisseur E1 constante en dehors de l'excroissance 19. L'excroissance 19 a une deuxième épaisseur E2, de sorte que la paroi 3 a au niveau de l'excroissance 19 une épaisseur égale à la somme des première et deuxième épaisseurs E1 et E2. La partie de protection 20b est plus précisément ménagée dans la paroi de la canalisation 2 comportant l'excroissance 19 à une distance E3 de l'intérieur de la canalisation 2 inférieure à la première épaisseur E1. En d'autres termes, la paroi 3 comprend localement une troisième épaisseur E3 au niveau de chaque cavité 20, cette troisième épaisseur étant inférieur à la première épaisseur E1.

Par exemple, la première épaisseur E1 est comprise entre 2 et 5 millimètres, et est typiquement de 3 millimètres, la deuxième épaisseur E2 est comprise entre 8 et 12 millimètres, et est typiquement de 10 millimètres, et la distance E3, ou troisième épaisseur E3, est comprise entre 0,3 et 1,7 millimètres, et est typiquement de 1 millimètre.

Dans un mode de réalisation, la partie de protection 20a a un diamètre D1 plus grand que le diamètre D2 de la partie de réception 20b. Plus précisément, la partie de réception 20b de chaque cavité 20 est configurée pour enserrer la deuxième portion 17 du module 13, 14, 15 insérée dans ladite cavité 20, de façon à maintenir et immobiliser le module 13, 14, 15 dans ladite cavité 20. Ainsi, le diamètre D2 de la partie de réception 20b est sensiblement voisin, par exemple supérieur d'un demi millimètre, au diamètre de la deuxième portion 17 des modules thermoélectriques 13, 14, 15. Par exemple, le diamètre D2 est compris entre 1 et 3 millimètres, et est typiquement de 2 millimètres.

Le diamètre de la partie de protection 20a est en revanche plus large, et configuré pour qu'aucun contact n'ait lieu entre le module 13, 14, 15 et la partie de protection 20a, de façon à isoler électriquement et thermiquement le module 13, 14, 15 en dehors de sa deuxième portion 17. Par exemple, le diamètre de la partie de protection 20a est compris entre 3 et 6 millimètres, et est typiquement de 4 millimètres.

L'épaisseur E2 radiale de l'excroissance 19 est configurée de sorte que la première portion 16 des modules 13, 14, 15 insérés dans la pluralité de cavités 20 est exposée à l'extérieur de la canalisation 2, c'est-à-dire en dehors de la partie de protection 20a. De cette manière, la première portion 16 est bien maintenue à température $T_{amb}$ de l'extérieur de la canalisation 2.

La deuxième portion 17 de chacun des modules thermoélectriques 13, 14, 15 est ainsi maintenue au contact de la partie de réception 20b, située au plus proche du fluide s'écoulant dans la canalisation 2, de sorte que la deuxième portion 17 est bien à la température $T_{fluide}$ du fluide. Optionnellement, un gel thermique isolant électriquement est appliqué sur la deuxième portion 17, de sorte que la conduction de chaleur du fluide à la deuxième portion 17 soit améliorée tout en évitant les pertes électriques au contact de la canalisation 2, qui peut comprendre du laiton. Enfin, l'espace libre entre la partie de protection 20a et le module thermoélectrique 13, 14, 15 logé dans ladite partie de protection 20a peut être rempli d'air ou d'un isolant thermique. Le premier commutateur S1 et le second commutateur S2 sont commandés par le bloc de commande 6 pour leur état : ouvert ou fermé pour le second commutateur S2, sélection de la voie d'alimentation pour le premier commutateur S1. Lorsque le second commutateur S2 est fermé et que le premier commutateur S1 connecte le bloc de commande 6 à la pile 12, qui alimente alors le bloc de commande 6, le condensateur C1 est couplé au générateur thermoélectrique 30 et se recharge, emmagasinant de l'énergie électrique produite par le générateur thermoélectrique 30. Lorsque le second commutateur S2 est ouvert et que le premier commutateur S1 connecte le bloc de commande 6 au condensateur C1 de la seconde voie d'alimentation 21, le bloc de commande 6 est alimenté par le condensateur C1, la pile 12 n'étant pas sollicitée.

Le second commutateur S2 est configuré pour être contrôlé par le bloc de commande 6 en fonction de la différence de température $\Delta T$ déterminée par le bloc de commande 6 d'une part lorsque le condensateur C1 est en état de charge, et en fonction d'un état de charge du condensateur C1 déterminé par le bloc de commande 6 d'autre part lorsque le condensateur C1 est en état de décharge.

Le premier commutateur S1 est configuré pour être contrôlé par le bloc de commande 6 en fonction d'un état de charge du condensateur C1 déterminé par le bloc de commande 6. Un état de charge ou de décharge du condensateur C1 est déterminé par le bloc de commande 6 à partir d'une estimation du courant I représentative d'une intensité du courant de charge ou de décharge du condensateur C1, ou estimation du courant I de charge ou de décharge.

Plus particulièrement, d'une part, l'estimation du courant I de charge est réalisée par le bloc de commande 6 et fondée sur une correspondance entre la différence de température $\Delta T$ entre l'extérieur de la canalisation 2 et le fluide déterminée par le bloc de commande 6 et une première table de correspondance (déterminée expérimentalement, et stockée par exemple dans la mémoire du bloc de commande 6) fournissant pour chaque valeur de $\Delta T$ une estimation du courant I.

D'autre part, l'estimation du courant I de décharge est réalisée par le bloc de commande 6 et fondée sur une correspondance entre des fonctions mises-en-œuvre par le bloc de commande 6 et une deuxième table de correspondance (déterminée expérimentalement, et stockée par exemple dans la mémoire du bloc de commande 6) fournissant pour chaque fonction mise-en-œuvre une estimation du courant I.

Le bloc de commande 6 est en effet configuré pour déterminer niveau de charge (SoC) du condensateur C1 à partir de cette estimation du courant I de charge ou de décharge. Plus précisément, le niveau de charge est mis à jour à chaque pas de temps grâce à l'estimation du courant I de charge ou de décharge.

Par exemple, lors de la charge du condensateur C1, le niveau de charge (SoC) à l'instant précédent est incrémenté par un multiple de l'intensité du courant I de charge. De préférence, le niveau de charge est exprimé en tant que proportion d'une réserve d'énergie maximale $E_{max}$ du condensateur C1. Il s'ensuit que l'expression de l'énergie, soit $V.I$, est divisée par $E_{max}$, avec V la valeur de la tension aux bornes du redresseur 22 délivrée par le générateur thermoélectrique 30 (V étant égale à $\Delta V$ multiplié par le nombre N de modules 13, 14, 15 assemblés en série dans le générateur thermoélectrique 30) et I l'intensité du courant de charge estimé par le bloc de commande 6 à l'aide de la différence de température $\Delta T$ et de la première table de correspondance, et donc que $SoC(t+T)= SoC(t)+T.V.I/E_{max}$.

A l'inverse, lors de la décharge du condensateur C1, le niveau de charge (SoC) à l'instant précédent est décrémenté par un multiple de l'intensité du courant I de décharge, d'où $SoC(t+T)= SoC(t)-T.V.I/E_{max}$, , avec V la valeur de la tension aux bornes du redresseur 22 délivrée par le générateur thermoélectrique 30 (V étant égale à $\Delta V$ multiplié par le nombre N de modules 13, 14, 15 assemblés en série dans le générateur thermoélectrique 30) et I l'intensité du courant de décharge estimé par le bloc de commande 6 à l'aide des fonctions mises-en-œuvre par le bloc de commande 6 et de la deuxième table de correspondance.

De préférence, le pas de temps T est inférieur à 10 secondes. Le pas de temps T est de préférence supérieur à 0,1 seconde. Pour des raisons de simplicité, le pas de temps est ici de 1 seconde, ce qui permet de simplifier la détermination du niveau de charge :

- en charge : $SoC(t+T)= SoC(t)+V.I/E_{max}$,
- en décharge : $SoC(t+T)= SoC(t)-V.I/E_{max}$.

Si l'état de charge est suffisamment haut, le premier commutateur S1 connecte la seconde voie d'alimentation 21 pour permettre l'alimentation du bloc de commande 6 par le condensateur C1 de la seconde voie d'alimentation 21. Sinon, le premier commutateur S1 connecte la première voie d'alimentation 11 pour permettre la recharge du condensateur C1 pendant que c'est la pile 12 de la première voie d'alimentation 11 qui alimente le bloc de commande 6. Le bloc de commande 6 est configuré pour, au moins lorsque le générateur thermoélectrique 30 génère de l'électricité :

- positionner le premier commutateur S1 sur la seconde voie d'alimentation 21 lorsque le niveau de charge devient supérieur ou égal à un seuil haut,
- positionner le premier commutateur S1 sur la première voie d'alimentation 11 lorsque le niveau de charge du condensateur C1 devient inférieur ou égal à un seuil bas.

De même, lorsque le premier commutateur S1 est connecté à la pile 12, et donc que le condensateur C1 est en phase de charge, le bloc de commande 6 est configuré pour :

- ouvrir le second commutateur S2 lorsque la différence de température $\Delta T$ est inférieure en valeur absolue à un seuil minimal de différence de température,
- fermer le second commutateur S2 lorsque la différence de température $\Delta T$ est supérieure ou égale en valeur absolue à un seuil minimal de différence de température et que la différence de température $\Delta T$ est de même signe que la différence définie par le deuxième coefficient de Seebeck $S_B$ moins le premier coefficient de Seebeck $S_A$.

Le même seuil minimal de température peut être utilisé, mais il est possible d'utiliser des seuils différents.

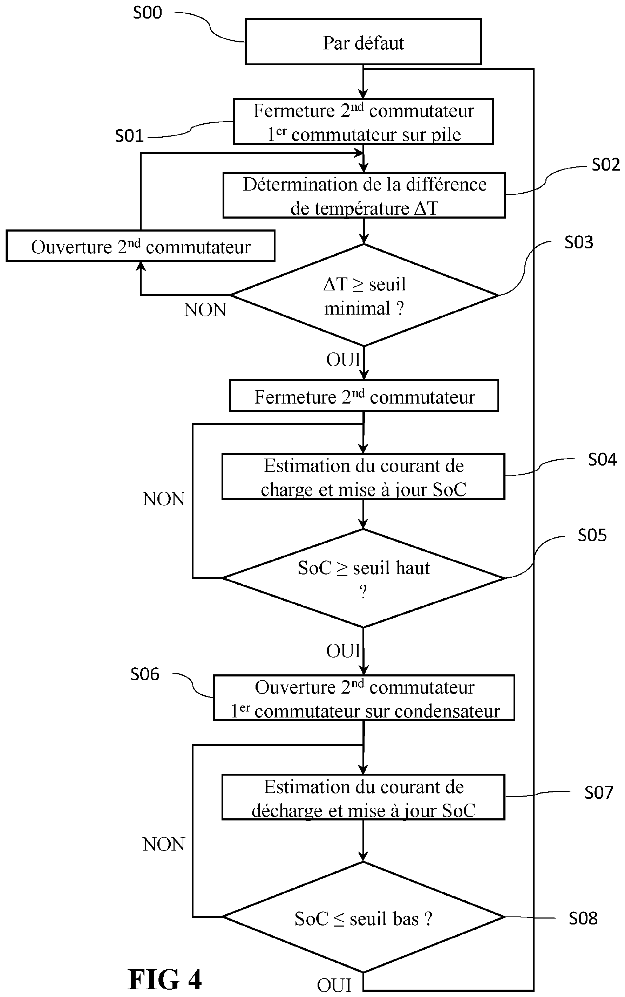

La figure 4 montre un exemple de diagramme de fonctionnement du compteur de fluide montrant les variations des états du premier commutateur S1 et du second commutateur S2, avec différentes étapes mises en œuvre par le bloc de commande 6. Dans un état par défaut (S00), par exemple avant la mise en place du compteur de fluide, le premier commutateur S1 est sur pile 12, c'est-à-dire connecte le bloc de commande 6 à la première voie d'alimentation 11. Le second commutateur S2 est de préférence fermé. La charge du condensateur C1 peut être nulle (auquel cas le niveau de charge est initialisé à 0) ou très faible (auquel cas le niveau de charge est initialisé en fonction de la valeur de charge initiale non nulle). Dans une première étape (S01), le second commutateur S2 est fermé, connectant le condensateur C1 au générateur thermoélectrique 30. Le premier commutateur S1 est sur pile 12. Le condensateur C1 peut alors se charger en énergie électrique. Dans une deuxième étape (S02), la différence de température $\Delta T$ entre l'extérieur de la canalisation 2 et le fluide est mesurée par le bloc de commande 6 recevant les mesures de $T_{amb}$ et $T_{fluide}$ réalisées par les capteurs de températures T1 et T2. La différence de température $\Delta T$ est comparée à un seuil minimal de différence de température, afin de déterminer si de l'électricité est produit par le générateur thermoélectrique 30 en quantité suffisante pour charger le condensateur C1. En fonction du résultat de la comparaison de la deuxième étape (S02), le second commutateur S2 est ouvert ou fermé (étape S03). Ainsi, si la différence de température $\Delta T$ est inférieure en valeur absolue au seuil minimal, alors le second commutateur S2 est ouvert. A l'inverse, si la différence de température $\Delta T$ est supérieure ou égale en valeur absolue à un seuil minimal (le même ou différent) et que la différence de température $\Delta T$ est de même signe que la différence entre le deuxième coefficient de Seebeck $S_B$ et le premier coefficient de Seebeck $S_A$, alors le second commutateur S2 est fermé, permettant la charge du condensateur C1. Par exemple, le seuil minimal de différence de température est compris entre 2°C et 5°C, et typiquement de 3°C.

Lorsque le deuxième commutateur S2 est fermé, une quatrième étape (S04) est mise-en-œuvre, dans laquelle le bloc de commande 6 estime le courant I de charge en fonction de la différence de température $\Delta T$ et de la première table de correspondance, et met à jour le niveau de charge en fonction de l'estimation du courant I de charge déterminée. Plus précisément, comme expliqué plus haut, l'état de charge est incrémenté par un multiple de l'estimation du courant I de charge. Ensuite, un test (S05) est effectué pour vérifier si le niveau de charge est supérieur ou égal à un seuil haut, au moyen d'une comparaison entre le niveau de charge courant et ce seuil haut. Le seuil haut sert à vérifier que le condensateur C1 est suffisamment chargé, et correspond donc à un niveau de charge proche de l'énergie maximale $E_{max}$ que peut stocker le condensateur. Typiquement, le seuil haut est d'au moins 80% de l'énergie maximale $E_{max}$, et de préférence d'au moins 90% de l'énergie maximale $E_{max}$.

Si ce n'est pas le cas, le bloc de commande 6 revient à la quatrième étape (S04) pour continuer la charge du condensateur C1. Si le niveau de charge est supérieur ou égal au seuil haut, alors le bloc de commande 6 commande l'ouverture du deuxième commutateur S2 et le passage du premier commutateur S1 sur le condensateur C1, couplant ainsi le bloc de commande 6 et la seconde voie d'alimentation 21 (étape S06). Le bloc de commande 6 est désormais alimenté par le condensateur C1 qui se décharge, et non plus par la pile 12. L'ouverture du premier commutateur S2 permet de découpler le condensateur C1 et le générateur thermoélectrique 30, évitant ainsi d'éventuelles perturbations électriques. Lors de la décharge du condensateur C1, à chaque pas de temps T est effectuée une étape (S07) d'estimation du courant I de décharge et une mise à jour du niveau de charge par le bloc de commande 6. Plus particulièrement, cette estimation du courant I de décharge est déterminée par le bloc de commande 6 différemment que dans l'étape S03. En effet, l'estimation du courant I est déterminée à partir des fonctions actives dans le pas de temps de l'étape S05 et de la deuxième table de correspondance. Plus précisément, on entend par fonction actives les fonctions mises-en-œuvre par le bloc de commande 6 (telles que l'activation du bloc de commande 6, l'envoi d'une trame, la réalisation d'une salve de mesure, ...). D'autre part, comme expliqué plus haut, le niveau de charge est décrémenté par un multiple de l'estimation du courant I de décharge. Ensuite, un test (S08) est effectué pour vérifier si le niveau de charge est inférieur ou égal à un seuil bas, au moyen d'une comparaison entre le niveau de charge courant et ce seuil bas. Le seuil bas sert à vérifier que le condensateur C1 a suffisamment été déchargé, et correspond donc à un niveau de charge proche du minimum. Typiquement, le seuil bas est inférieur à 10% de l'énergie maximale $E_{max}$, et est par exemple inférieur ou égal à 5% de $E_{max}$.

Si le niveau de charge est supérieur au seuil bas, la décharge du condensateur C1 se poursuit et une nouvelle étape (S07) d'estimation du courant I de décharge et de mise à jour du niveau de charge est effectuée. A l'inverse, si le niveau de charge est inférieur ou égal au seuil bas, cela signifie que le condensateur C1 a été suffisamment déchargé, et qu'il doit maintenant être rechargé. Par conséquent, le bloc de commande 6 retourne alors à l'étape (S01), ferme le deuxième commutateur S2 et commute le premier commutateur S1 vers la première voie d'alimentation 11, sur la pile 12.

Enfin, le bloc de commande 6 est configuré pour mettre en œuvre un produit programme d'ordinateur comportant des instructions qui, lorsqu'elles sont exécutées par le bloc de commande 6, conduisent à la mise-en-œuvre du procédé décrit ci-dessus.

Le produit programme d'ordinateur prend la forme d'un support non-volatile, typiquement une mémoire lisible par ordinateur stockant des instructions qui, lorsqu'elles sont exécutées par un ordinateur, conduisent celui-ci à mettre en œuvre le procédé décrit ci-dessus.

Ainsi que visible dans ce procédé, le bloc de commande 6 est configuré pour maximiser l'utilisation du condensateur C1 et économiser la pile 12. La pile 12 n'est alors utilisée que pour permettre la recharge du condensateur C1. Grâce à la permanence de l'alimentation électrique, le compteur de fluide est capable de communiquer des informations relatives aux données métrologiques, par exemple en les affichant, même en l'absence de circulation de fluide. Il est à noter que le temps de charge du condensateur C1 est inversement proportionnel à la différence de température ΔT entre l'extérieur et le fluide, de sorte que l'invention est particulièrement adaptée à un compteur d'eau chaude. Il est aisé de faire en sorte, eu égard aux faibles besoins énergétiques du bloc de commande 6, que le temps de recharge du condensateur C1 soit beaucoup plus court que le temps de décharge du condensateur C1. Le condensateur C1 peut assurer une part significative de l'alimentation du bloc de commande 6. La pile 12, moins sollicitée, peut être choisie avec une capacité de stockage énergétique moindre, avec par conséquent un encombrement réduit et un coût moins important, tout en préservant ou augmentant sa durée de vie.

Le générateur thermoélectrique 30 utilisé dans la présente invention présente l'avantage de ne pas être intrusif dans le fluide, et ainsi de ne pas risquer de perturber la précision de la métrologie. Aussi, un tel générateur thermoélectrique 30 élimine tout risque de casse ou d'encrassement par rapport à un autre générateur électrique intrusif.

Aussi, la solution présentée dans le présent exposé est économique, le surcoût lié à la fabrication de l'excroissance et au perçage des cavités étant très limité.

L'invention n'est pas limitée au mode de réalisation décrit et représenté aux figures annexées. Des modifications restent possibles, notamment du point de vue de la constitution des diverses caractéristiques techniques ou par substitution d'équivalents techniques, sans sortir pour autant du domaine de protection de l'invention.

**Revendications**

1. Compteur de fluide configuré pour effectuer des mesures métrologiques dans une canalisation de circulation de fluide et pour communiquer des informations relatives auxdites données métrologiques, comprenant :

   - une canalisation de fluide (2),
   - au moins un capteur métrologique (4) configuré pour effectuer des mesures métrologiques dans la canalisation de fluide (2),
   - un bloc de commande (6) configuré pour recevoir les mesures métrologiques et pour communiquer des informations relatives auxdites données métrologiques,
   - un bloc d'alimentation (10) configuré pour alimenter en énergie le bloc de commande (6), le bloc d'alimentation (10) comprenant une première voie d'alimentation (11) comprenant au moins une pile (12), et une seconde voie d'alimentation (21), le bloc d'alimentation (10) comprenant en outre un premier commutateur (S1) configuré pour coupler sélectivement la première voie d'alimentation (11) ou la seconde voie d'alimentation (21) au bloc de commande (6),

   le compteur de fluide comprend un générateur thermoélectrique (30) configuré pour produire de l'électricité à partir d'une différence de température (ΔT) entre un extérieur de la canalisation (2) et le fluide dans la canalisation (2), la seconde voie d'alimentation (21) étant reliée au générateur thermoélectrique (30).

2. Compteur de fluide selon la revendication 1, dans lequel le générateur thermoélectrique (30) comporte un ou plusieurs modules thermoélectriques (13, 14, 15) insérés partiellement dans une paroi (3) de la canalisation (2).

3. Compteur de fluide selon la revendication 2, dans lequel une excroissance (19) est formée sur la canalisation (2) de circulation du fluide, l'excroissance (19) comprenant au moins une cavité (20), chaque cavité (20) étant configurée pour recevoir un module thermoélectrique (13, 14, 15).

4. Compteur de fluide selon la revendication 3, dans lequel la paroi (3) de la canalisation (2) a une première épaisseur (E1) en dehors de l'excroissance (19), chaque cavité (20) comprenant une partie de protection (20a) et une partie de réception (20b), la partie de réception (20b) étant d'un diamètre inférieur à la partie de protection (20a) et étant ménagée dans la paroi (3) de la canalisation (2) à une distance (E3) de l'intérieur de la canalisation (2) inférieure à la première épaisseur (E1), chaque module thermoélectrique (13, 14, 15) comprenant une première portion (16) configurée pour être à la température de l'extérieur de la canalisation ($T_{amb}$) et une deuxième portion (17) configurée pour être à la température du fluide ($T_{fluide}$), la deuxième portion (17) étant insérée dans la partie de réception (20b).

5. Compteur de fluide selon la revendication 4, dans lequel le générateur thermoélectrique (30) comporte un premier connecteur externe (18a) en contact avec la première portion (16) d'un premier module thermoélectrique (14) disposé en entrée du générateur thermoélectrique (30) et reliant ladite première portion (16) au bloc d'alimentation (10), le générateur thermoélectrique (30) comprenant en outre un deuxième connecteur externe (18b) en contact avec la deuxième portion (17) d'un dernier module thermoélectrique (15) disposé en sortie du générateur thermoélectrique (30) et reliant ladite deuxième portion (17) au bloc d'alimentation (10).

6. Compteur de fluide selon la revendication 4 ou 5, dans lequel une deuxième portion (17) d'un module thermoélectrique (13, 14) est reliée par un connecteur interne (18c) à la première portion (16) d'un autre module thermoélectrique (13, 15).

7. Compteur de fluide selon la revendication 5 ou 6, dans lequel chaque module thermoélectrique (13, 14, 15) est composé d'un premier matériau thermoélectrique ayant un premier coefficient de Seebeck ($S_A$), et un connecteur (18a, 18b, 18c) en contact avec la première portion (16) ou la deuxième portion (17) du module thermoélectrique est composé d'un deuxième matériau thermoélectrique ayant un deuxième coefficient de Seebeck ($S_B$) différent du premier coefficient de Seebeck ($S_A$).

8. Compteur de fluide selon l'une quelconque des revendications 1 à 7, dans lequel la seconde voie d'alimentation (21) comprend un condensateur (C1) et un second commutateur (S2) configuré pour sélectivement coupler le condensateur (C1) et le générateur thermoélectrique (30) en fonction d'un niveau de charge (SoC) du condensateur (C1),

9. Compteur de fluide selon la revendication 8, dans lequel le niveau de charge (SoC) est déterminé par le bloc de commande (6) en fonction d'une première table de correspondance et de la différence de température ($\Delta T$) lorsque le condensateur (C1) se charge, et en fonction d'une deuxième table de correspondance et de fonctions mises-en-œuvre par le bloc de commande (6) lorsque le condensateur (C1) se décharge.

10. Compteur de fluide selon la revendication 8 ou 9, dans lequel le bloc de commande (6) est configuré pour, au moins lorsque le générateur thermoélectrique (30) génère de l'électricité :

   - positionner le premier commutateur (S1) sur la seconde voie d'alimentation (21) lorsque le niveau de charge (SoC) devient supérieur à un seuil haut,
   - positionner le premier commutateur (S1) sur la première voie d'alimentation (11) lorsque le niveau de charge (SoC) du condensateur (C1) devient inférieur à un seuil bas.

11. Compteur de fluide selon la revendication 10, dans lequel le seuil haut est supérieur ou égal à 80% d'un niveau de charge maximal ($E_{max}$), et le seuil bas est inférieur ou égal à 10% du niveau de charge maximal ($E_{max}$).

12. Compteur de fluide selon l'une quelconque des revendications précédentes, dans lequel le bloc de commande (6) est configuré pour déterminer une différence de température ($\Delta T$) entre l'extérieur de la canalisation (2) et le fluide et pour :

   - ouvrir le second commutateur (S2) lorsque la différence de température ($\Delta T$) est inférieure à un seuil minimal de différence de température,
   - fermer le second commutateur (S2) lorsque la différence de température ($\Delta T$) est supérieure ou égale à un seuil minimal de différence de température.

13. Compteur de fluide selon la revendication 12, dans lequel le seuil minimal de différence de température est compris entre 2°C et 5°C.

14. Procédé de gestion de l'alimentation d'un compteur de fluide selon l'une quelconque des revendications 1 à 13, le compteur de fluide comprenant un bloc de commande (6) et un bloc d'alimentation (10) configuré pour alimenter en énergie le bloc de commande (6), le bloc d'alimentation (10) comprenant une première voie d'alimentation (11) comprenant au moins une pile (12), et une seconde voie d'alimentation (21), le bloc d'alimentation (10) comprenant en outre un premier commutateur (S1) configuré pour coupler sélectivement la première voie d'alimentation (11) ou la seconde voie d'alimentation (21) au bloc de commande (6), la seconde voie d'alimentation (21) étant reliée à un générateur thermoélectrique (30) configuré pour produire de l'électricité à partir d'une

différence de température (∆T) entre un extérieur de la canalisation (2) et le fluide dans la canalisation (2), la seconde voie d'alimentation (21) comprenant en outre un condensateur (C1) et un second commutateur (S2) configuré pour sélectivement coupler le condensateur (C1) et le générateur thermoélectrique (30) en fonction d'un niveau de charge du condensateur (C1), le procédé étant apte à être mis-en-œuvre par le bloc de commande (6) et comportant les étapes suivantes :

- Commutation du premier commutateur (S01) sur la première voie d'alimentation (11),
- Détermination (S02) d'une différence de température (∆T) entre un extérieur de la canalisation (2) et le fluide et, lorsque la différence de température déterminée (∆T) devient supérieure ou égale à un seuil minimal, fermeture (S03) du deuxième commutateur (S2),
- Estimation (S04) d'un courant (I) de charge à partir de la différence de température (∆T) et d'une première table de correspondance fournissant une estimation du courant de charge associé pour chaque valeur de la différence de température (∆T),
- Détermination (S04) d'un niveau de charge (SoC) du condensateur (C1) en charge à partir du courant (I) de charge estimé et, lorsque le niveau de charge (SoC) estimé devient supérieur ou égal à un seuil haut prédéterminé, commutation (S06) du premier commutateur (S1) sur la deuxième voie d'alimentation (21),
- Estimation (S07) d'un courant (I) de décharge réalisée à partir de fonctions mises-en-œuvre par le bloc de commande (6) et d'une deuxième table de correspondance fournissant pour chaque fonction mise-en-œuvre par le bloc de commande (6) une estimation du courant (I) de décharge associé,
- Détermination (S07) d'un niveau de charge (SoC) du condensateur (C1) en décharge en fonction de l'estimation du courant (I) de décharge et, lorsque le niveau de charge (SoC) estimé devient inférieur ou égal à un seuil bas de charge prédéterminé, répétition des étapes précédentes.

15. Produit programme d'ordinateur apte à être mis-en-œuvre par un bloc de commande (6) d'un compteur de fluide selon l'une quelconque des revendications 1 à 13, comprenant des instructions qui, lorsque le programme est exécuté par le bloc de commande (6), conduisent le bloc de commande (6) à mettre en œuvre le procédé selon la revendication 14.

16. Mémoire lisible par ordinateur stockant des instructions exécutables par l'ordinateur pour l'exécution des étapes du procédé selon la revendication 14.

**Patentansprüche**

1. Fluidzähler, der ausgelegt ist, um metrologische Messungen in einer Fluidzirkulationsleitung durchzuführen und Informationen bezüglich der metrologischen Daten zu übermitteln, umfassend:

    - eine Fluidleitung (2),
    - mindestens einen metrologischen Sensor (4), der ausgelegt ist, um metrologische Messungen in der Fluidleitung (2) durchzuführen,
    - einen Steuerblock (6), der ausgelegt ist, um die metrologischen Messungen zu empfangen und Informationen bezüglich der metrologischen Daten zu übermitteln,
    - einen Versorgungsblock (10), der ausgelegt ist, um den Steuerblock (6) mit Energie zu versorgen, wobei der Steuerblock (10) einen ersten Versorgungsweg (11), der mindestens einer Batterie (12) umfasst, und einen zweiten Versorgungsweg (21) umfasst, wobei der Versorgungsblock (10) ferner einen ersten Schalter (S1) umfasst, der ausgelegt ist, um wahlweise den ersten Versorgungsweg (11) oder den zweiten Versorgungsweg (21) mit dem Steuerblock (6) zu koppeln,

    wobei der Fluidzähler einen thermoelektrischen Generator (30) umfasst, der ausgelegt ist, um aus einer Temperaturdifferenz (∆T) zwischen einem Außenbereich der Leitung (2) und dem Fluid in der Leitung (2) Elektrizität zu erzeugen, wobei der zweite Versorgungsweg (21) mit dem thermoelektrischen Generator (30) verbunden ist.

2. Fluidzähler nach Anspruch 1, wobei der thermoelektrische Generator (30) ein oder mehrere thermoelektrische Module (13, 14, 15) umfasst, die teilweise in eine Wand (3) der Leitung (2) eingesetzt sind.

3. Fluidzähler nach Anspruch 2, wobei an der Fluidzirkulationsleitung (2) ein Vorsprung (19) ausgebildet ist, wobei der Vorsprung (19) mindestens eine Vertiefung (20) umfasst, wobei jede Vertiefung (20) zur Aufnahme eines thermoelektrischen Moduls (13, 14, 15) ausgebildet ist.

4. Fluidzähler nach Anspruch 3, wobei die Wand (3) der Leitung (2) außerhalb des Vorsprungs (19) eine erste Dicke (E1) aufweist, wobei jede Vertiefung (20) einen Schutzteil (20a) und einen Aufnahmeteil (20b) umfasst, wobei der Aufnahmeteil (20b) einen kleineren Durchmesser als der Schutzteil (20a) hat und in der Wand (3) der Leitung (2) in einem Abstand (E3) vom Inneren der Leitung (2) angeordnet ist, der kleiner als die erste Dicke (E1) ist, wobei jedes thermoelektrische Modul (13, 14, 15) einen ersten Abschnitt (16), der ausgelegt ist, um auf der Temperatur der Außenbereich der Leitung ($T_{amb}$) zu sein, und einen zweiten Abschnitt (17) umfasst, der ausgelegt ist, um auf der Temperatur des Fluids ($T_{fluide}$) zu sein, wobei der zweite Abschnitt (17) in den Aufnahmeteil (20b) eingesetzt ist.

5. Fluidzähler nach Anspruch 4, wobei der thermoelektrische Generator (30) einen ersten externen Verbinder (18a) aufweist, der mit dem ersten Abschnitt (16) eines ersten thermoelektrischen Moduls (14) in Kontakt steht, das am Eingang des thermoelektrischen Generators (30) angeordnet ist und den ersten Abschnitt (16) mit dem Versorgungsblock (10) verbindet, wobei der thermoelektrische Generator (30) ferner einen zweiten externen Verbinder (18b) umfasst, der mit dem zweiten Abschnitt (17) eines letzten thermoelektrischen Moduls (15) in Kontakt steht, das am Ausgang des thermoelektrischen Generators (30) angeordnet ist und den zweiten Abschnitt (17) mit dem Versorgungsblock (10) verbindet.

6. Fluidzähler nach Anspruch 4 oder 5, wobei ein zweiter Abschnitt (17) eines thermoelektrischen Moduls (13, 14) über einen inneren Verbinder (18c) mit dem ersten Abschnitt (16) eines weiteren thermoelektrischen Moduls (13, 15) verbunden ist.

7. Fluidzähler nach Anspruch 5 oder 6, wobei jedes thermoelektrische Modul (13, 14, 15) aus einem ersten thermoelektrischen Material mit einem ersten Seebeck-Koeffizienten ($S_A$) besteht und ein Verbinder (18a, 18b, 18c) in Kontakt mit dem ersten Abschnitt (16) oder dem zweiten Abschnitt (17) des thermoelektrischen Moduls aus einem zweiten thermoelektrischen Material mit einem zweiten Seebeck-Koeffizienten ($S_B$) besteht, der sich vom ersten Seebeck-Koeffizienten ($S_A$) unterscheidet.

8. Fluidzähler nach einem der Ansprüche 1 bis 7, wobei der zweite Versorgungsweg (21) einen Kondensator (C1) und einen zweiten Schalter (S2) umfasst, der ausgelegt ist, um den Kondensator (C1) und den thermoelektrischen Generator (30) in Abhängigkeit von einem Ladezustand (SoC) des Kondensators (C1) wahlweise zu koppeln.

9. Fluidzähler nach Anspruch 8, wobei der Ladezustand (SoC) vom Steuerblock (6) in Abhängigkeit von einer ersten Zuordnungstabelle und von der Temperaturdifferenz ($\Delta T$) beim Laden des Kondensators (C1) und in Abhängigkeit von einer zweiten Zuordnungstabelle und von Funktionen, die vom Steuerblock (6) beim Entladen des Kondensators (C1) ausgeführt werden, bestimmt wird.

10. Fluidzähler nach Anspruch 8 oder 9, wobei der Steuerblock (6) ausgelegt ist, um zumindest dann, wenn der thermoelektrische Generator (30) Strom erzeugt:

   - den ersten Schalter (S1) auf den zweiten Versorgungsweg (21) zu positionieren, wenn der Ladezustand (SoC) über einen oberen Schwellenwert steigt,
   - den ersten Schalter (S1) auf den ersten Versorgungsweg (11) zu positionieren, wenn der Ladezustand (SoC) des Kondensators (C1) unter einen unteren Schwellenwert fällt.

11. Fluidzähler nach Anspruch 10, wobei der obere Schwellenwert größer oder gleich 80 % eines maximalen Ladezustands ($E_{max}$) ist und der untere Schwellenwert kleiner oder gleich 10 % des maximalen Ladezustands ($E_{max}$) ist.

12. Fluidzähler nach einem der vorhergehenden Ansprüche, wobei der Steuerblock (6) ausgelegt ist, um eine Temperaturdifferenz ($\Delta T$) zwischen dem Außenbereich der Leitung (2) und dem Fluid zu bestimmen und um:

   - den zweiten Schalter (S2) zu öffnen, wenn die Temperaturdifferenz ($\Delta T$) unter einem minimalen Temperaturdifferenz-Schwellenwert liegt,
   - den zweiten Schalter (S2) zu schließen, wenn die Temperaturdifferenz ($\Delta T$) größer oder gleich einem minimalen Temperaturdifferenz-Schwellenwert ist.

13. Fluidzähler nach Anspruch 12, wobei der minimale Temperaturdifferenz-Schwellenwert zwischen 2 °C und 5 °C liegt.

14. Verfahren zur Verwaltung der Versorgung eines Fluidzählers nach einem der Ansprüche 1 bis 13, wobei der Fluidzähler einen Steuerblock (6) und einen Versorgungsblock (10) umfasst, der ausgelegt ist, um den Steuerblock (6) mit Energie zu versorgen, wobei der Versorgungsblock (10) einen ersten Versorgungsweg (11), der mindestens eine Batterie (12) umfasst, und einen zweiten Versorgungsweg (21) umfasst, wobei der Versorgungsblock (10) ferner einen ersten Schalter (S1) umfasst, der ausgelegt ist, um wahlweise den ersten Versorgungsweg (11) oder den zweiten Versorgungsweg (21) mit dem Steuerblock (6) zu koppeln, wobei der zweite Versorgungsweg (21) mit einem thermoelektrischen Generator (30) verbunden ist, der ausgelegt ist, um aus einer Temperaturdifferenz ($\Delta T$) zwischen einem Außenbereich der Leitung (2) und dem Fluid in der Leitung (2) Elektrizität zu erzeugen, wobei der zweite Versorgungsweg (21) ferner einen Kondensator (C1) und einen zweiten Schalter (S2) umfasst, der ausgelegt ist, um den Kondensator (C1) und den thermoelektrischen Generator (30) in Abhängigkeit von einem Ladezustand des Kondensators (C1) wahlweise zu koppeln, wobei das Verfahren imstande ist, durch den Steuerblock (6) durchgeführt zu werden und die folgenden Schritte aufweist:

- Schalten des ersten Schalters (SOI) auf den ersten Versorgungsweg (11),
- Ermitteln (S02) einer Temperaturdifferenz (ΔT) zwischen einem Außenbereich der Leitung (2) und dem Fluid und, wenn die ermittelte Temperaturdifferenz (ΔT) größer oder gleich einem minimalen Schwellenwert wird, Schließen (S03) des zweiten Schalters (S2),
- Schätzen (S04) eines Ladestroms (I) anhand der Temperaturdifferenz (ΔT) und einer ersten Zuordnungstabelle, die für jeden Wert der Temperaturdifferenz (ΔT) eine Schätzung des zugehörigen Ladestroms liefert,
- Ermitteln (S04) eines Ladezustands (SoC) des Kondensators (C1) beim Laden anhand des geschätzten Ladestroms (I) und, wenn der geschätzte Ladezustand (SoC) größer oder gleich einem vorgegebenen oberen Schwellenwert wird, Schalten (S06) des ersten Schalters (S1) auf den zweiten Versorgungsweg (21),
- Schätzen (S07) eines Entladestroms (I), das anhand von Funktionen durchgeführt wird, die vom Steuerblock (6) durchgeführt werden, und einer zweiten Zuordnungstabelle, die für jede vom Steuerblock (6) ausgeführte Funktion eine Schätzung des zugehörigen Entladestroms (I) liefert,
- Ermitteln (S07) eines Ladezustands (SoC) des Kondensators (C1) beim Entladen in Abhängigkeit von der Schätzung des Entladestroms (I) und, wenn der geschätzte Ladezustand (SoC) kleiner oder gleich einem vorgegebenen niedrigen Ladeschwellenwert wird, Wiederholung der vorherigen Schritte.

15. Rechnerprogrammprodukt, das durch einen Steuerblock (6) eines Fluidzählers nach einem der Ansprüche 1 bis 13 ausführbar ist, das Anweisungen umfasst, die, wenn das Programm durch den Steuerblock (6) ausgeführt wird, den Steuerblock (6) veranlassen, das Verfahren nach Anspruch 14 auszuführen.

16. Rechnerlesbarer Speicher, der vom Rechner ausführbare Anweisungen zur Ausführung der Verfahrensschritte nach Anspruch 14 speichert.

**Claims**

1. A fluid meter configured to perform metrological measurements in a fluid circulation pipe and to communicate information relating to said metrological data, comprising:

- a fluid pipe (2),
- at least one metrological sensor (4) configured to perform metrological measurements in the fluid pipe (2),
- a control block (6) configured to receive the metrological measurements and to communicate information relating to said metrological data,
- a power supply block (10) configured to supply energy to the control block (6), the power supply block (10) comprising a first supply path (11) comprising at least one primary cell (12), and a second supply path (21), the power supply block (10) further comprising a first switch (S1) configured to selectively couple the first supply path (11) or the second supply path (21) to the control block (6),

**characterized in that** the fluid meter comprises a thermoelectric generator (30) configured to produce electricity from a temperature difference (ΔT) between an exterior of the pipe (2) and the fluid in the pipe (2), the second supply path (21) being connected to the thermoelectric generator (30).

2. The fluid meter according to claim 1, wherein the thermoelectric generator (30) includes one or more thermoelectric modules (13, 14, 15) partially inserted into a wall (3) of the pipe (2).

3. The fluid meter according to claim 2, wherein a protrusion (19) is formed on the fluid circulation pipe (2), the protrusion (19) comprising at least one cavity (20), each cavity (20) being configured to receive a thermoelectric module (13, 14, 15).

4. The fluid meter according to claim 3, wherein the wall (3) of the pipe (2) has a first thickness (E1) out of the protrusion (19), each cavity (20) comprising a protection part (20a) and a receiving part (20b), the receiving part (20b) being of a diameter smaller than the protection part (20a) and being arranged in the wall (3) of the pipe (2) at a distance (E3) from the interior of the pipe (2) smaller than the first thickness (E1), each thermoelectric module (13, 14, 15) comprising a first portion (16) configured to be at the temperature of the exterior of the pipe ($T_{amb}$) and a second portion (17) configured to be at the temperature of the fluid ($T_{fluid}$), the second portion (17) being inserted into the receiving part (20b).

5. The fluid meter according to claim 4, wherein the thermoelectric generator (30) includes a first external connector (18a) in contact with the first portion (16) of a first thermoelectric module (14) disposed at the input of the thermoelectric generator (30) and connecting said first portion (16) to the power supply block (10), the thermoelectric generator (30) further comprising a second external connector (18b) in contact with the second portion (17) of a last thermoelectric module (15) disposed at the output of the thermoelectric generator (30) and connecting said second portion (17) to the power supply block (10).

6. The fluid meter according to claim 4 or 5, wherein a second portion (17) of a thermoelectric module (13, 14) is connected by an internal connector (18c) to the first portion (16) of another thermoelectric module (13, 15).

7. The fluid meter according to claim 5 or 6, wherein each thermoelectric module (13, 14, 15) is composed of a first thermoelectric material having a first Seebeck coefficient ($S_A$), and a connector (18a, 18b, 18c) in contact with the first portion (16) or the second portion (17) of the thermoelectric module is composed of a second thermoelectric material having a second Seebeck coefficient ($S_B$) different from the first Seebeck coefficient ($S_A$).

8. The fluid meter according to any one of claims 1 to 7, wherein the second supply path (21) comprises a capacitor (C1) and a second switch (S2) configured to selectively couple the capacitor (C1) and the thermoelectric generator (30) according to a level of charge (SoC) of the capacitor (C1),

9. The fluid meter according to claim 8, wherein the level of charge (SoC) is determined by the control block (6) according to a first correspondence table and to the temperature difference ($\Delta T$) when the capacitor (C1) is charging, and according to a second correspondence table and to functions implemented by the control block (6) when the capacitor (C1) is discharging.

10. The fluid meter according to claim 8 or 9, wherein the control block (6) is configured, at least when the thermoelectric generator (30) generates electricity:

    - to position the first switch (S1) on the second supply path (21) when the level of charge (SoC) becomes greater than a high threshold,
    - to position the first switch (S1) on the first supply path (11) when the level of charge (SoC) of the capacitor (C1) becomes smaller than a low threshold.

11. The fluid meter according to claim 10, wherein the high threshold is greater than or equal to 80% of a maximum level of charge ($E_{max}$), and the low threshold is less than or equal to 10% of a maximum level of charge ($E_{max}$).

12. The fluid meter according to any one of the preceding claims, wherein the control block (6) is configured to determine a temperature difference ($\Delta T$) between the exterior of the pipe (2) and the fluid and:

    - to open the second switch (S2) when the temperature difference ($\Delta T$) is smaller than a minimum temperature difference threshold,
    - to close the second switch (S2) when the temperature difference ($\Delta T$) is greater than or equal to a minimum temperature difference threshold.

13. The fluid meter according to claim 12, wherein the minimum temperature difference threshold is comprised between 2°C and 5°C.

14. A method for managing the supply of a fluid meter according to any one of claims 1 to 13, the fluid meter comprising a control block (6) and a power supply block (10) configured to supply energy to the control block (6), the power supply block (10) comprising a first supply path (11) comprising at least one primary cell (12), and a second supply path (21), the power supply block (10) further comprising a first switch (S1) configured to selectively couple the first supply path (11) or the second supply path (21) to the control block (6), the second supply path (21) being connected to a thermoelectric generator (30) configured to produce electricity from a temperature difference ($\Delta T$) between an exterior of the pipe (2) and the fluid in the pipe (2), the second supply path (21) further comprising a capacitor (C1) and a second switch (S2) configured to selectively couple the capacitor (C1) and the thermoelectric generator (30) according to a level of charge of the capacitor (C1), the method being able to be implemented by the control block (6) and including the following steps:

    - Switching the first switch (S01) on the first supply path (11),
    - Determining (S02) a temperature difference ($\Delta T$) between an exterior of the pipe (2) and the fluid and, when the determined temperature difference ($\Delta T$) becomes greater than or equal to a minimum threshold, closing (S03) the second switch (S2),
    - Estimating (S04) a charge current (I) from the temperature difference ($\Delta T$) and a first correspondence table providing an estimation of the associated charge current for each value of the temperature difference ($\Delta T$),
    - Determining (S04) a level of charge (SoC) of the capacitor (C1) in charge from the estimated charge current (I) and, when the estimated level of charge (SoC) becomes greater than or equal to a predetermined high threshold, switching (S06) the first switch (S1) on the second supply path (21),

- Estimating (S07) a discharge current (I) from functions implemented by the control block (6) and a second correspondence table providing for each function implemented by the control block (6) an estimation of the associated discharge current (I),

- Determining (S07) a level of charge (SoC) of the capacitor (C1) in discharge according to the estimation of the discharge current (I) and, when the estimated level of charge (SoC) becomes smaller than or equal to a predetermined low charge threshold, repeating the previous steps.

15. A computer program product able to be implemented by a control block (6) of a fluid meter according to any one of claims 1 to 13, comprising instructions which, when the program is executed by the control block (6), cause the control block (6) to implement the method according to claim 14.

16. A computer-readable memory storing instructions executable by the computer for the execution of the steps of the method according to claim 14.

**FIG 1**

**FIG 2**

**FIG 3**

**FIG 4**

S00 — Par défaut

S01 — Fermeture 2$^{nd}$ commutateur
1$^{er}$ commutateur sur pile

S02 — Détermination de la différence
de température $\Delta T$

S03 — $\Delta T \geq$ seuil minimal ?

Ouverture 2$^{nd}$ commutateur

NON

OUI

Fermeture 2$^{nd}$ commutateur

S04 — Estimation du courant de
charge et mise à jour SoC

S05 — SoC $\geq$ seuil haut ?

NON

OUI

S06 — Ouverture 2$^{nd}$ commutateur
1$^{er}$ commutateur sur condensateur

S07 — Estimation du courant de
décharge et mise à jour SoC

NON

S08 — SoC $\leq$ seuil bas ?

OUI

**EP 4 450 928 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2002270908 A